(19) Europäisches Patentamt
European Patent Office
Office européen des brevets

(11) Numéro de publication: **0 223 627**
**B1**

(12) **FASCICULE DE BREVET EUROPEEN**

(45) Date de publication du fascicule du brevet: **25.04.90**

(51) Int. Cl.$^5$: **H 03 K 19/094**

(21) Numéro de dépôt: **86402008.6**

(22) Date de dépôt: **12.09.86**

(54) **Circuit de conversion d'une entrée différentielle en niveaux logiques CMOS.**

(30) Priorité: **17.09.85 FR 8513758**

(43) Date de publication de la demande:
**27.05.87 Bulletin 87/22**

(45) Mention de la délivrance du brevet:
**25.04.90 Bulletin 90/17**

(84) Etats contractants désignés:
**DE FR IT NL SE**

(56) Documents cités:
**US-A-4 453 095**

**ELECTRICAL DESIGN NEWS, vol. 18, no. 10, 20 mai 1973, pages 56-63, Denver, US; A.D. EVANS: "The basics of using FETs for analog-signal switching"**

(73) Titulaire: **THOMSON-CSF**
**51, Esplanade du Général de Gaulle**
**F-92800 Puteaux (FR)**

(72) Inventeur: **Le Roux, Gérard**
**Thomson-CSF SCPI 19 avenue de Messine**
**F-75008 Paris (FR)**
Inventeur: **Vialettes, Françoise**
**Thomson-CSF SCPI 19 avenue de Messine**
**F-75008 Paris (FR)**

(74) Mandataire: **de Beaumont, Michel**
**1bis, rue Champollion**
**F-38000 Grenoble (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

EP 0 223 627 B1

**Description**

Le présente invention concerne le domaine des circuits logiques et plus particulièrement un circuit de conversion propre à convertir des signaux d'entrée correspondants à une première famille logique en signaux logiques compatibles avec des bascules logiques de type CMOS.

Par exemple, si l'on veut commander des bascules logiques CMOS par des signaux logiques provenant directement d'une logique de type TTL, étant donné la plage de variations des niveaux logique TTL, il se peut que les niveaux logiques haut et bas soient insuffisament différenciés pour permettre une commande sûre d'une logique CMOS. A titre d'exemple numérique, un circuit logique CMOS nécessite une tension de seuil de l'ordre de 1,5 V alors que le circuit logique TTL a une tension de seuil de 1,4 V mais qui peut varier entre 0,8 et 2 V en fonction de divers paramètres tels que des fluctuations de tension d'alimentation, des variations de température, etc.

Un objet plus particulier de la présente invention est de réaliser un tel circuit de conversion qui puisse fonctionner à vitesse élevée, par exemple à une fréquence de l'ordre de 10 MHz pour un niveau haut de 12 V, un tel circuit pouvant par exemple être utilisé dans des commandes de panneaux à plasma. Une autre exigence pour la commande de panneaux à plasma est de réal'iser un circuit présentant une bonne immunité aux bruits parasites car, sur la même puce de circuit intégré que celle comprenant la logique CMOS, se trouvent des commutateurs pour le panneau à plasma qui commutent des tensions pouvant varier de 0 à plus 100 V, par exemple.

Parmi les circuits de l'art antérieur destinés à assurer une conversion entre signaux logiques d'une première famille et signaux logiques pour bascule CMOS on trouve:

— des circuits dans lesquels l'entrée se fait sur la base d'un transistor PNP. De tels circuits ne peuvent étre utilisés pour atteindre les objets de la présente invention étant donné le défaut de vitesse inhérent aux transistors PNP sur silicium dont la fréquence maximale est limitée à des valeurs de l'ordre de 1 à 4 MHz;

— des circuits dans lesquels on place en entrée un inverseur CMOS dont les dimensions sont fortement déséquilibrées; ceci ne permet pas non plus d'atteindre les vitesses souhaitées car le fait d'utiliser des transitors MOS de grande dimension entraîne que ceux-ci ont des capacités parasites importantes et donc que leur vitesse de fonctionnement est réduite;

— des circuits réalisés totalement en CMOS tels que décrits dans le document US—A—4 453 095 sans transistor bipolaire mais alors, de façon inhérente, on ne peut résoudre les difficultés liées à la création d'un niveau de tension suffisament bas pour la bascule CMOS comme tension de seuil inférieure.

Ainsi, pour atteindre les objets énoncés ci-dessus et éviter les inconvénients des dispositifs de l'art antérieur, la présente invention prévoit un circuit de conversion d'une entrée différentielle en niveaux logiques CMOS comprenant:

un comparateur d'entrée comprenant deux transistors bipolaires de type NPN reliés par leurs émetteurs et recevant les signaux d'entrée différentiels sur leurs bases;

une bascule CMOS comprenant deux branches constituées chacune d'une transistor MOS à canal P en série avec deux transistors MOS à canal N, les grilles des deuxièmes transistors MOS à canal N de chaque branche étant connectées pour fixer le courant de ces branches à l'état passant, les grilles des premiers transistors MOS à canal N de chaque branche étant connectées aux drains des transistors à canal P de l'autre branche et à une borne de sortie.

Dans ce circuit:

— la deuxième branche du comparateur est reliée à la tension d'alimentation VCC par une charge constituée d'un transistor MOS à canal P, et à la grille du transistor MOS à canal P de la première branche de la bascule;

— la deuxième branche de la bascule CMOS est reliée à la tension d'alimentation VCC par un transistor bipolaire NPN dont la base est connectée à un moyen pour fournir un premier potentiel prenant l'une ou l'autre de deux valeurs selon l'état de l'entrée et est connectée aussie à la deuxième branche du comparateur; et

— la grille du transistor à canal P de la deuxième branche de la bascule est connectée à un moyen pour fournir un deuxième potentiel déterminé lié aux valeurs du premier pour assurer la condition ou le blocage de ce transistor et donc l'état de la bascule CMOS.

Dans un mode de réalisation de ce circuit de conversion:

— les moyens pour fournir les premier et deuxième potentiels déterminés comprennent: un premier circuit série constitué d'un transistor MOS à canal P, de deux transistors bipolaires du type NPN montés en diodes et d'une source de courant;

— les grilles des transistors MOS à canal P des premier et second circuits série sont interconnectées et sont connectées à la grille du transistor à canal P de la deuxième branche du comparateur, ces grilles étant reliées au drain du transistor MOS à canal P du premier circuit série ou à un point de tensrieure à celle de ce drain;

— le drain du transistor à canal P du premier circuit série est connecté à la base d'un transistor bipolaire de type NPN qui est connecté son émetteur à la base du transistor bipolaire de la deuxième branche de la bascule et par son collecteur à la tension d'alimentation;

— un point du premier circuit série, ayant une tension inférieure de 2 VBE à la tension de drain du transistor MOS à canal P de ce circuit, est connecté à la grille du transistor à canal P de la seconde branche de la bascule.

Dans un mode de réalisation de ce circuit de conversion, les premier et second circuits série peuvent être communs à un grand nombre de tels circuits de conversion pour un ensemble de bascules logiques CMOS.

Ces objets, caractéristiques et avantages ainsi que d'autres de la présente invention seront exposés plus en détail dans la description suivante de modes de réalisation particuliers faite en relation avec les figures jointes parmi lesquelles:

— la figure 1 représente un schéma de principe d'un circuit selon la présente invention;

— les figures 2 et 3 reprennent le schéma de la figure 1 mais on y a en outre indiqué des valeurs de tensions et des sens de parcours de courants pour chacun des états du signal d'entrée; et

— la figure 4 indique un mode de réalisation détaillé de la présente invention.

Comme le représente la figure 1, le circuit selon la présente invention est alimenté entre une borne d'alimentation VCC et la masse.

Ce circuit comprend un comparateur d'entrée 10, une bascule CMOS 20 et des circuits pour alimenter, commander et contrôler de façon adéquate ce comparateur et cette bascule.

Le comparateur d'entrée 10 est un comparateur à transistors bipolaires de type NPN. Comme on l'a noté précédemment, ce choix de transistors de type NPN n'est pas dû au hasard maise est nécessaire pour atteindre les rapidités de fonctionnement que l'on vise. Plus particulièrement, le comparateur comprend un premier transistor NPN Q1 et un deuxième transistor NPN Q2 dont les émetteurs sont interconnectés et reliés à une source de courant I. La base du transistor Q1 est connectée à un borne d'entrée E1 qui reçoit le signal logique à convertir; la base du transistor Q2 est connectée à une borne d'entrée E2 qui reçoit un signal de référence choisi pour être nettement intermédiaire entre les valeurs haute et basse possibles du niveau logique à la borne d'entrée E1. Le collecteur du transistors Q1 est relié à la tension d'alimentation VCC. Le collecteur du transistor Q2 est relié à cette tension d'alimentation VCC par l'intermédiaire d'une charge constituée d'un transistor MOS à canal P, P1.

La bascule CMOS 20 comprend deux branches. La première branche comprend en série un transistor MOS à canal P, P3, un transistor MOS à canal N, N1 et un transistor MOS à canal N, N3. La deuxième branche comprend un transistor à canal P, P4, un transistor MOS à canal N, N2, et un transistor MOS à canal N, N4. Comme on le verra ci-après, les transistors N3 et N4 sont essentiellement des sources de courant destinées à assurer la circulation de courant dans la bascule lors des phases de commutation. En effet, il convient que cette circulation de courant soit suffisament élevée pour que la commutation puisse être rapide. La grille du transistor N1 de la première branche est connectée au drain du transistor P4 de la deuxième branche et de même la grille du transistor N2 est connectée au drain du transistor P3. Ces connexions constituent également les sorties directe, S, et complémentaire, S', de la bascule. Les sources de seconds transistors N3 et N4 sont reliées à la masse. La source du transistor P3 est connectée à la tension d'alimentation VCC et la source du transistor P4 est connectée à VCC par l'intermédiaire d'un transistor Q4. La grille du transistor P3 reçoit la sortie du comparateur 10 sur la borne du collecteur du transistor Q2.

En outre, la base du transistor Q4 est reliée à la tension d'alimentation VCC par l'intermédiaire d'un transistor Q3. Ce point de connexion est également connecté au collecteur du transistor Q2.

Les circuits d'alimentation, de commande et de contrôle comprennent un premier circuit série comprenant en série un transistor MOS à canal P, P2, deux transistors bipolaires de type NPN, Q5 et Q6, montés en diodes et une source de courant IREF, ce premier circuit série étant connecté entre la borne d'alimentation VCC et la masse. Un second circuit série connecté entre la tension d'alimentation VCC et la masse comprend un transistor MOS à canal P, P5, et un transistor MOS à canal N, N5, dont le drain et la grille sont reliés. Les grilles de transistors P2 et P5 sont interconnectées et ce point de connexion est connecté à la grille du transistor P1 et au point de raccordement des deux diodes Q5 et Q6. Le drain du transistor P2 est connecté à la base du transistor Q3. Le point de connexion entre la deuxième diode Q6 et la source de courant IREF et relié à la grille du transistor P4. La grille du transistor N5 est reliée aux grilles des transistors N2 et N4.

Fonctionnement du circuit dans le cas où le signal d'entrée est à niveau haut

La figure 2 illustre plus en détail le fonctionnement du circuit dans le cas où le signal d'entrée sur la borne E1 est à niveau haut, c'est-à-dire que le tension à la borne E1 est supérieure à la tension à la borne E2. En ce cas, le transistor Q1 est conducteur (passant) et le transistor Q2 est bloqué. Le transistor P1 étant normalement à l'état passant, le potential à la borne de collecteur 11 du transistor Q2 remonte jusqu'à la tension d'alimentation VCC. En conséquence, le transistor P3, dont la grille est au même potentiel que la source, est bloqué et le transistor P4 est amené à l'état passant puique sa source est au potentiel VCC—VBE (chute de tension base-émetteur dans le transistor Q4) et que sa grille est au potentiel VCC—VDSP2—2VBE imposée par la circulation de courant dans le premier circuit série P2, Q5, Q6. Le transistor Q3 dont l'émetteur et le collecteur sont au même potentiel et dont la base est à un potentiel plus faible est bloqué.

Le transistor P4 étant à l'état passant, son drain vient sensiblement au même potentiel que sa source ce'est-à-dire VCC—VBE. C'est la tension sur la borne de sortie directe, S, de la bascule CMOS. La circulation de courant dans le transistor P1, la jonction base-émetteur du transistor Q4, et le transistor P4 rend le transistor N1 passant. La source de courant constituée par le transistor N3 tire alors la sortie S' vers la masse (puisque le transistor P3 est bloqué), ce qui a pour effet de bloquer le transistor N2 et de renforcer ainsi l'état haut à la sortie S. En conclusion, l'état d'équilibre atteint quand l'entrée E1 est à niveau haut, est un état où:

S = VCC—VBE S' = O.

Lors de cet état d'équilibre, le courant dans les deux branches de la bascule CMOS devient nul.

Fonctionnement du circuit dans le cas où le signal d'entrée est à niveau bas

En ce cas, illustré en figure 3, dans le comparateur d'entrée, le transistor Q1 est bloqué tandis que le transistor Q2 est passant. Alors, un courant circule dans le transistor P1 et le transistor Q2. Du fait de cette conduction dans le transistor P1, la tension à la borne 11 est égale à VCC — la chute de tension drain-source dans le transistor P1 (VDSP1). Le potentiel sur l'émetteur du transistor Q3 devient inférieur au potentiel sur son collecteur alors que son potentiel de base est toujours VCC — VDSP2. Ce transistor conduit alors et un courant circule également vers le transistor Q2 en passant par le transistor Q3. Ainsi, le courant imposé, I, dans le transistor Q2 est la somme du courant I1 dans le transistor P1 et du courant I2 dans le transistor Q3. Le transistor P3 de la bascule 20 dont le potential de grille devient inférieur au potentiel de drain devient conducteur faisant ainsi passer le potentiel sur la borne de sortie S' de la bascule à la valeur VCC. Par suite, le transistor N2 devient passant et le transistor N4 agissant comme une source de courant fait descendre la borne S vers O ce qui abaisse le potential de source du transistor P4 vers le potentiel de la borne 11 (c'est-à-dire VCC—VDSP1) diminué de la chute de tension base-émetteur du transistor Q4, VBEQ4, car toute la chain Q4, P4, N2, N4 est alors momentanément conductrice. Cette conduction s'arrête dès que la tension grille-source du transistor P4 devient inférieure à la tension de seuil de ce transistor. Le point S est alors amené à O par les transistors N2, N4. Simultanément, cette descente du potentiel à la borne S bloque le transistor N1 ce qui confirme la remontée de la borne S' à VCC.

L'état d'équilibre atteint, quand le potentiel sur l'entrée E1 est inférieur au potentiel sur l'entrée E2, est donc S = O est S' = VCC, le courant dans les deux branches de la bascule (P2, N1, N3 et Q4, P4, N2, N4) étant nul.

Ainsi, le circuit selon la présente invention présente une légère dissymétrie en sortie puisque, dans un premier état, la sortie S est à VCC—VBE et S' à O alors que, dans un deuxième état, la tension S' est à VCC et la tension S à O. Néanmoins, en pratique, ceci ne présente pas un inconvénient pour la commande de portes CMOS surtout si l'on note que VCC est une tension de l'ordre de 12 V et VBE une tension de l'ordre de 0,7 V.

Bien sûr, la présente invention est susceptible de diverses variantes de réalisation, l'un des aspects essentiels résidant dans le fait que, dans l'état où la bascule CMOS doit avoir sa sortie S à O et sa sortie S' à haut niveau, la tension sur la grille du transistor MOS P3 (VCC—VDSP1) diffère de la tension sur la grille du transistor MOS P4 (VCC—VDSP2—2VBE) d'une valeur égale à VBE, en notant que VDSP2 est égal à VDSP1—VBE dans le mode de réalisation précédemment décrit. Ainsi, par exemple, la borne commune de grille des transistors P1, P2, P5 peut être connectée entre la diode Q5 et le drain du transistor P2 au lieu d'être connectée entre les deux diodes Q5 et Q6. Egalement, on pourra compliquer le circuit en rajoutant des transistors supplémentaires du moment que l'on retrouve les mêmes différences de tension aux points critiques du circuit c'est-à-dire notamment sur les grilles des transistors P3 et P4.

La figure 4 représente un mode de réalisation plus détaillé de la présente invention dans lequel, notamment, la source de courant I dans le comparateur bipolaire et la source de courant IREF dans le premier circuit série (P2, Q5, Q6, IREF) sont explicitées, ainsi que le circuit pour fournir une tension de référence sur l'entrée E2 du comparateur d'entrée 10.

On ne décrira ici que les éléments du circuit de la figure 4 qui diffèrent de ceux de la figure 1.

La source de courant I de la figure 1 est réalisée par la connexion en série d'un transistor bipolaire NPN Q8 et d'une résistance R1 entre les émetteurs des transistors bipolaires Q1, Q2 et la masse. La base du transistor Q8 est connectée aux bases de transistors Q9 et Q10 qui seront décrits ci-après.

La source de courant IREF dans le circuit série P2, Q5, Q6, IREF est réalisée par la connexion en série d'un transistor bipolaire NPN Q9 et d'une résistance R2 entre la diode Q6 et la masse. La base du transistor Q9 est connectée à la base d'un transistor Q10 dont l'émetteur est connecté à la masse par l'intermédiaire d'une résistance R3 et le collecteur à la tension d'aliementation par l'intermédiaire d'un transistor PNP QP1. Ce transistor QP1 est monté en miroir de courant avec un transistor de type PNP QP2 dont la base et le collecteur sont reliés, dont l'émetteur est connecté à la borne VCC et dont le collecteur est connecté à la masse par l'intermédiaire de la connexion en série d'un transistor bipolaire de type NPN Q12 et d'une résistance R4. Le potentiel sur la base du transistor Q12 est fixé par un diode Zener Z alimentée par une source de courant réalisée à l'aide d'un transistor de type JFET. La base des transistors Q9 et Q10 est reliée à la borne d'alimentation VCC par un transistor bipolaire de type NPN Q11 dont la base est reliée au collecteur du transistor Q10. Les bases des transistors Q9 et Q10 sont reliées comme on l'a vu précédemment à la base du transistor Q8 connecté pour servir de source de courant au comparateur d'entrée.

La tension de référence fournie à l'entrée E2 du comparateur 10 est réalisée par la connexion de cette entrée E2 à la borne VCC par l'intermédiaire bipolaire Q7 de type NPN, cette borne étant également reliée à la masse par l'intermédiaire d'une source de courant réalisée au moyen d'un transistor de type JFET. La base du transistor Q7 est connectée à un circuit de référence de tension qui peut être commun à un grand nombre de

circuits. Ce circuit de référence de tension, connecté entre VCC et la masse, comprend un transistor de type PNP QP3 avec une source de courant JFET, la source de courant étant reliée à la borne VCC et le collecteur du transistor PNP QP3 à la masse. La polarisation de base du transistor QP3 est assurée par un diviseur à résistance R5, R6.

**Revendications**

1. Circuit de conversion d'une entrée différentielle en niveaux logiques CMOS comprenant:

un comparateur d'entrée (10) comprenant deux transistors bipolaires de type NPN (Q1, Q2) reliés par leurs émetteurs et recevant les signaux d'entrée différentiels (E1, E2) sur leurs bases;

une bascule CMOS (20) comprenant deux branches constituées chacune d'un transistor MOS à canal P (P3, P4) en série avec deux transistors MOS à canal N (N1, N3; N2, N4), les grilles des deuxièmes transistors MOS à canal N (N3, N4) de chaque branche étant connectées pour fixer le courant de ces branches à l'état passant, les grilles des premiers transistors MOS à canal N (N1, N2) de chaque branche étant connectées aux drains des transistors à canal P (P4, P3) de l'autre branche et à une borne de sortie; caractérisé en ce que:

— la deuxième branche de comparateur est reliée:

à la tension d'alimentation VCC par une charge constituée d'un transitor MOS à canal P (P1), et

à la grille du transistors MOS à canal P (P3) de la première branche de la bascule;

— la deuxième branche de la bascule CMOS est reliée à la tension d'alimentation VCC par un transistor bipolaire NPN (Q4) dont la base est connectée à u moyen pour fournir un premier potential prenant l'une ou l'autre de deux valeurs selon l'état de l'entrée et est connectée aussi à la deuxième branche du comparateur; et

— la grille du transistor à canal P (P4) de la deuxième branche de la bascule est connectée à un moyen pour fournir un second potentiel constant par rapport auquel sont déterminées les valeurs du premier potentiel pour assurer la conduction ou le blocage de ce transistor et donc l'état de la bascule CMOS.

2. Circuit de conversion selon la revendication 1, caracterisé en ce que:

les moyens pour fournir les premier et second potentiels déterminés comprennent: un premier circuit série constitué d'un transistor MOS à canal P (P2) et de deux transistors bipolaires de type NPN montés en diodes (Q5 et Q6) et d'une source de courant;

— les grilles de transistors MOS à canal P des premier et second circuits série sont interconnectées et sont connectées à la grille du transistor à canal P (P1) de la deuxième branche du comparateur, ces grilles étant reliées au drain du transistors MOS à canal P du premier circuit série ou à un point de tension inférieure à celle de ce drain;

— le drain du transistor à canal P du premier circuit série (P2) est connecté à la base d'un transistor bipolaire NPN (Q3) qui est connecté par son émetteur à la base du transistor bipolaire (Q4) de la deuxième branche de la bascule et par son collecteur à la tension d'alimentation; et

— un point du premier circuit série, ayant une tension inférieure de 2 VBE à la tension de drain du transistor à canal P de ce circuit, est connecté à la grille du transistor MOS à canal P (P4) de la seconde branche de la bascule.

3. Circuit de conversion selon la revendication 2, caractérisé en ce que les premier et second circuits série sont communs à un grand nombre de tels circuits de conversion pour un ensemble de bascules logiques CMOS.

**Patentansprüche**

1. Konversionskreis zum Umwandeln eines differentiellen Eingangssignals in logische CMOS-Pegel, mit einem Eingangskomparator (10), der zwei bipolare NPN-Transistoren (Q1, Q2) aufweist, welche über ihre Emitter miteinander verbunden; sind und auf ihren Basen differentielle Eingangssignale (E1, E2) erhalten; einem CMOS-Flip-Fop (20) mit zwei Zweigen, wobei jeder Zweig aus einem P-Kanal-MOS-Transistor (P3, P4) in Reihe mit zwei N-Kanal-MOS-Transistoren (N1, N3; N2, N4) aufgebaut ist, wobei die Gatter der zweiten N-Kanal-MOS-Transistoren (N3, N4) jedes Zweiges so verbunden sind, daß der Strom in diesen Zweigen im Durchgangszustand gehalten ist, und wobei die Gatter der ersten N-Kanal-MOS-Transistoren (N1, N2) jedes Zweiges mit den Anoden der P-Kanal-Transistoren (P4, P3) des anderen Zweiges und mit einem Ausgangsanscluß verbunden sind; dadurch gekennzeichent, daß

— der zweite Zweig des Komparators

mit der Versorgungsspannung (VCC) über eine durch einen P-Kanal-MOS-Transistor (P1) gebildete Last und

mit dem Gatter des P-Kanal-MOS-Transistors (P3) des ersten Zweiges des Flip-Flops verbunden ist;

— der zweite Zweig des CMOS-Flip-Flops mit der Versorgungsspannung (VCC) über einen bipolaren NPN-Transistor (Q4) verbunden ist, dessen Basis mit einer Einrichtung zum Liefern einer ersten Potentials, das den einen oder anderen von zwei Werten entsprechend dem Zustand des Eingangssignals annimmt, verbunden ist und auch mit dem zweiten Zweig des Komparators verbunden ist; und

— das Gatter des P-Kanal-Transistors (P4) des zweiten Zweiges des Flip-Flops mit einer Einrichtung zum Leifern eines zweiten konstanten Potentials, in Bezug auf das die Werte des ersten Potentials bestimmt sind, um den Durchgang oder das Sperren dieses Transistors un somit den Zustand des CMOS-Flip-Flops sicherzustellen, verbunden ist.

2. Konversionskreis nach Anspruch 1, dadurch gekennzeichnet, daß

— die Einrichtungen zum Liefern des ersten und des zweiten festgelegten Potentials eine erste

Serienschaltung aus einem P-Kanal-MOS-Transistor (P2) und zwei über Dioden (Q5 und Q6) geschalteten bipolaren NPN-Transistoren une einer Stromquelle aufweisen;

— die Gatter der P-Kanal-MOS-Transistoren der ersten und der zweiten Serienschaltung miteinander verbuden sind und mit dem Gatter des P-Kanal-Transistors (P1) des zweiten Zweiges des Komparators verbunden sind, wobei diese Gatter mit der Anode des P-Kanal-MOS-Transitors der ersten Serienschlatung oder mit einem Punkt nierdrigerer Spannung als der der Anode verbunden sind;

— die Anode des P-Kanal-Transistors des ersten Serienkreises (P2) mit der Basis eines bipolaren NPN-Transistors (Q3) verbunden ist, der über seinen Emitter mit der Basis des bipolaren Transistors (Q4) des zweiten Zweiges des Flip-Flops und seinem Kollektor mit der Versorgungsspannung verbunden ist; und

— ein Punkt der ersten Serienschaltung mit einer Spannung um 2 VBE niedriger als die Anodenspannung des P-Kanal-Transistors dieser Schaltung mit dem Gatter des P-Kanal-MOS-Transistors des zweiten Zweiges des Flip-Flops verbunden ist.

3. Konversionskreis nach Anspruch 2, dadurch gekennzeichnet, daß die ersten und zweiten Serienschaltungen einer großen Anzahl solcher Koversionskreise für eine Anordnung von logischen CMOS-Flip-Flops gemeinsam sind.

## Claims

1. A conversion circuit for converting a differential input into CMOS logic levels comprising:

— an input comparator (10) comprising two NPN-type bipolar transistors (Q1, Q2) connected by their emitters and receiving differential input signals (E1, E2) on their bases;

— a CMOS flip-flop (20) comprising two branches each of which is constituted by a P channel MOS transistor (P3, P4) in series with two N channel MOS transistors (N1, N3; N2, N4), the gates of the second N channel MOS transistors (N3, N4) of each branch being connected in order to set the current of these branches at the passing state, and the gates of the first N channel MOS transistors (N1, N2) of each branch being connected to the drains of the P channel transistors (P4, P3) of the other branch and to an output terminal; characterized in this that:

— the second branch of the comparator is connected to:

the supply voltage (VCC) through a lead constituted by a P channel MOS transistor (P1), and

the gate of the P channel MOS transistor (P3) of the first branch of the flip-flop;

— the second branch of the CMOS flip-flop is connected to the supply voltage (VCC) by an NPN bipolar transistor (Q4), the base of which is connected to a means for supplying a first potential taking one or other of two values according to the state of the input and is also connected to the second branch of the comparator; and

— the gate of the P channel transistor (P4) of the second branch of the flip-flop is connected to a means for supplying a second constant potential with respect to which are determined the values of the first potential in order to ensure the conducting or the blocking of this transistor and thus the state of the CMOS flip-flop.

2. A conversion circuit according to claim 1, characterized in this that:

— the means for supplying the first and second determined potentials comprise: a first series circuit constituted by a P channel MOS transistor (P2), two diode-connected NPN-type bipolar transistors (Q5 and Q6) and a current supply;

— the gates of the P channel MOS transistors of the first and second series circuits are interconnected and are also connected to the gate of the P channel transistor (P1) of the second branch of the comparator, these gates being connected to the drain of the P channel MOS transistor of the first series circuit or to a voltage point lower than that of this drain;

— the drain of the P channel transistor (2) of the first series circuit is connected to the base of an NPN bipolar transistor (Q3) which is connected by its emitter to the base of the bipolar transistor (Q4) of the second branch of the flip-flop and by its collector to the supply voltage; and

— a point of the first series circuit, having a voltage lower than the drain voltage of the P channel MOS transistor of this circuit by a value of 2VBE, is connected to the gate of the P channel transistor (P4) of the second branch of the flip-flop.

3. A conversion circuit according to claim 2, characterized in this that the first and second series circuits are common to a large number of such conversion circuits in an assembly of CMOS logic flip-flops.

FIG_1

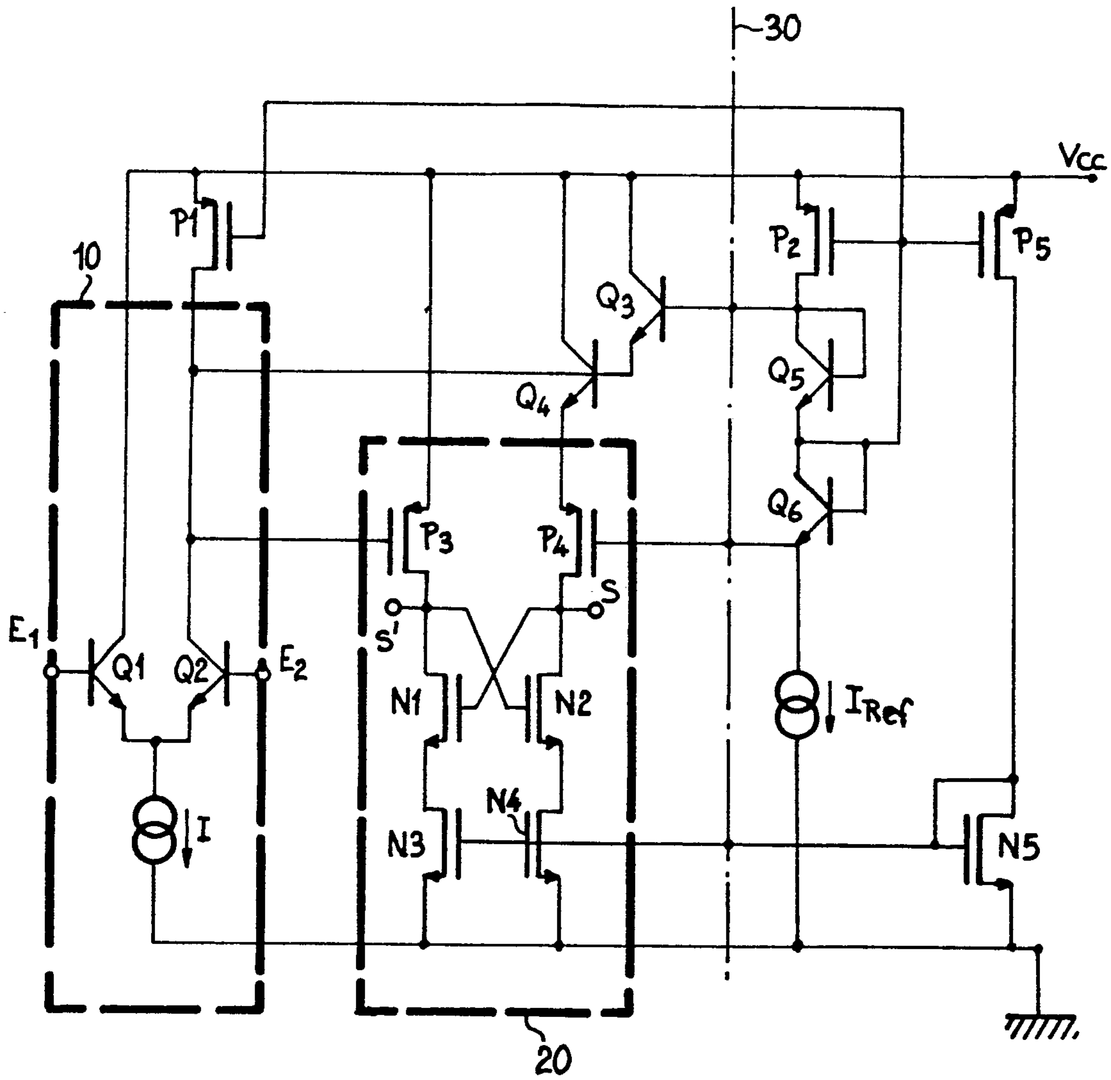
30
Vcc
P1
10
P2
P5
Q3
Q5
Q4
Q6
P3
P4
S
S'
E1
E2
Q1
Q2
N1
N2
IRef
I
N4
N3
N5
20

FIG_2

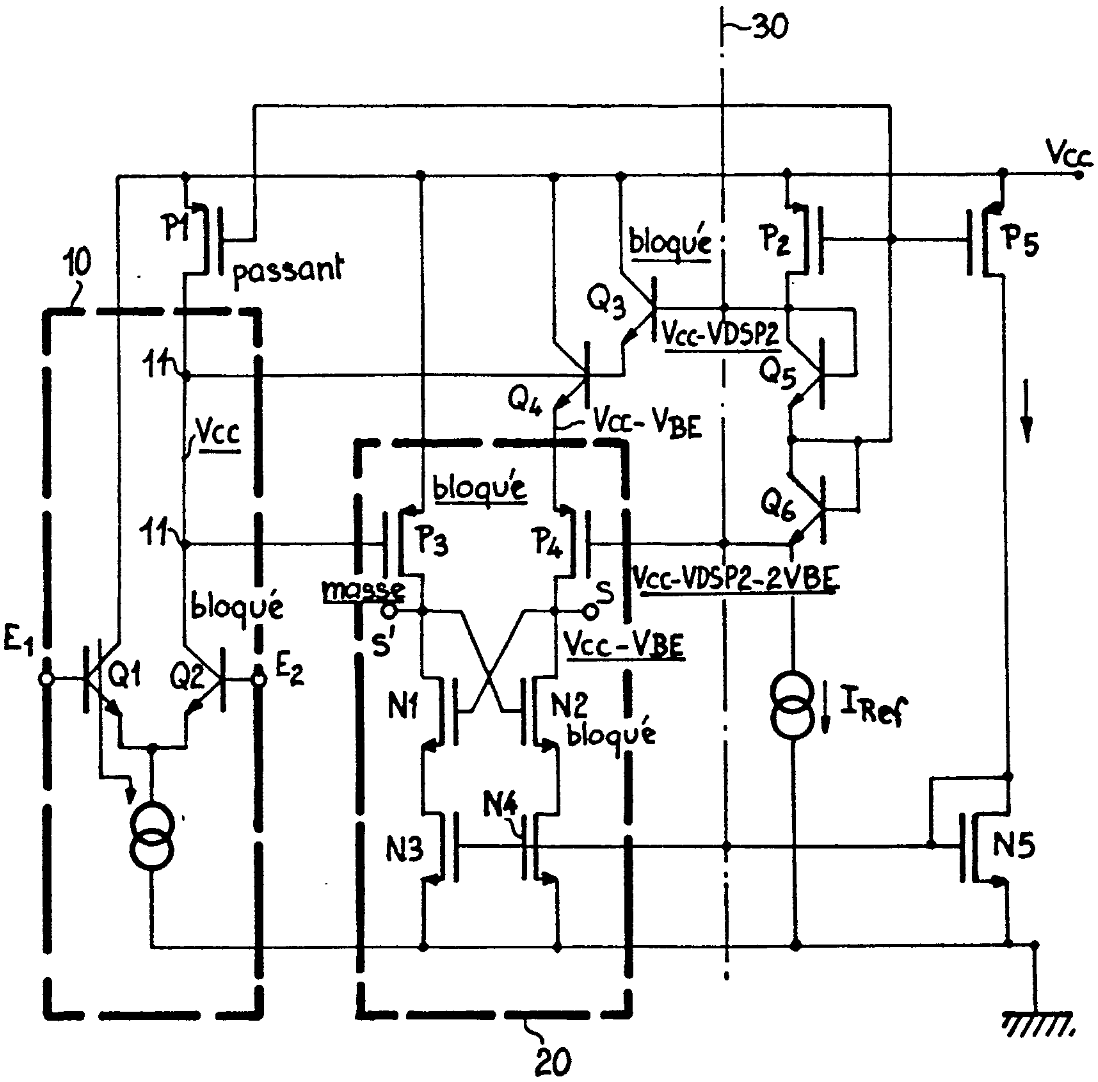
30
Vcc
P1
passant
10
P2
P5
bloqué
Q3
Vcc-VDSP2
Q5
Q4
Vcc- VBE
11
Vcc
bloqué
Q6
P3
P4
Vcc-VDSP2-2VBE
masse
S
S'
bloqué
E1
Q1
Q2
E2
Vcc-VBE
N1
N2
bloqué
IRef
N4
N3
N5
20

FIG_3

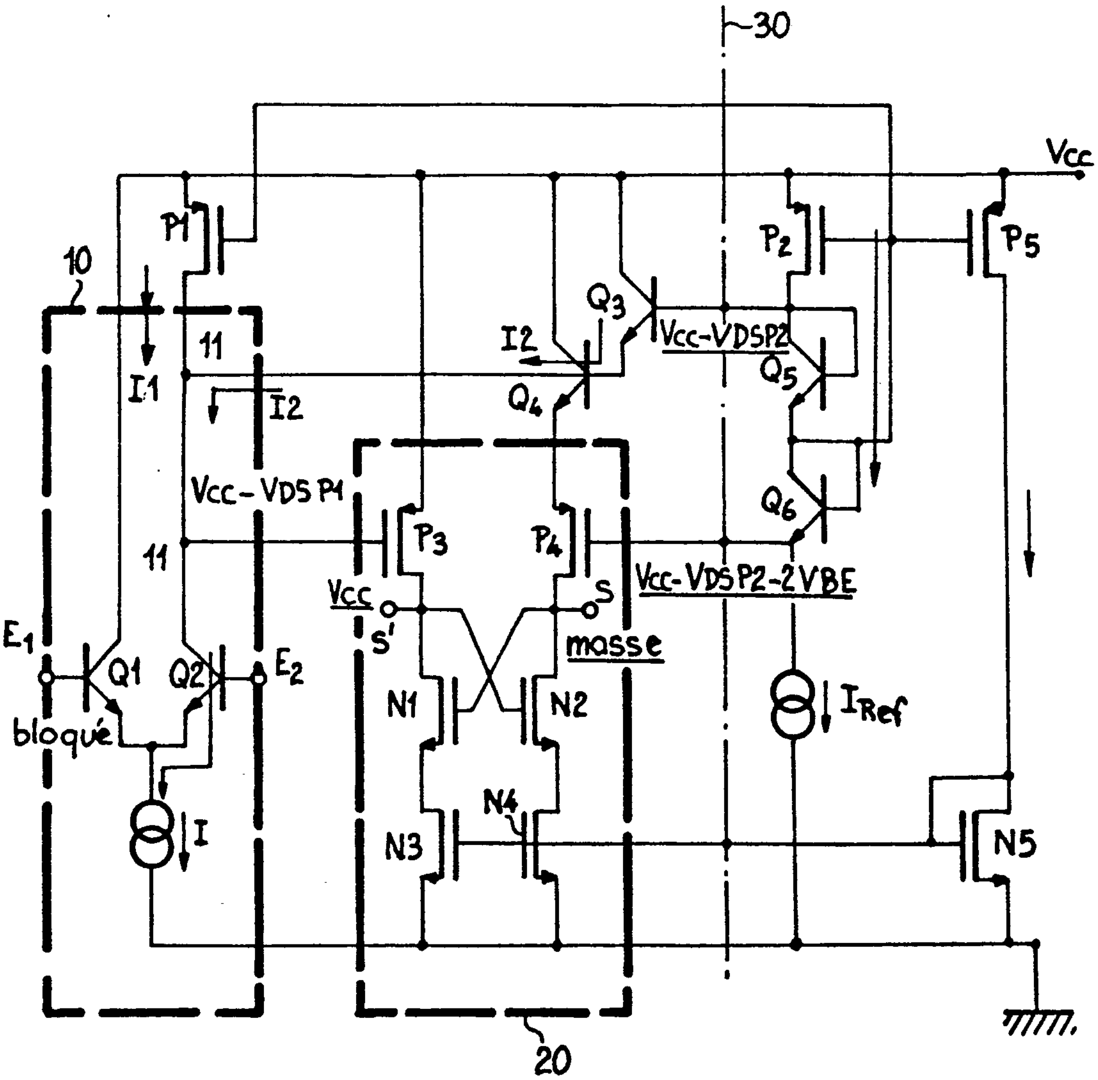
30
Vcc
P1
P2
P5
10
Q3
11
I2
Vcc-VDSP2
I1
Q5
I2
Q4
Vcc-VDS P1
Q6
P3
P4
11
Vcc-VDSP2-2VBE
Vcc
S
S'
masse
E1
Q1
Q2
E2
bloqué
N1
N2
IRef
I
N4
N3
N5
20

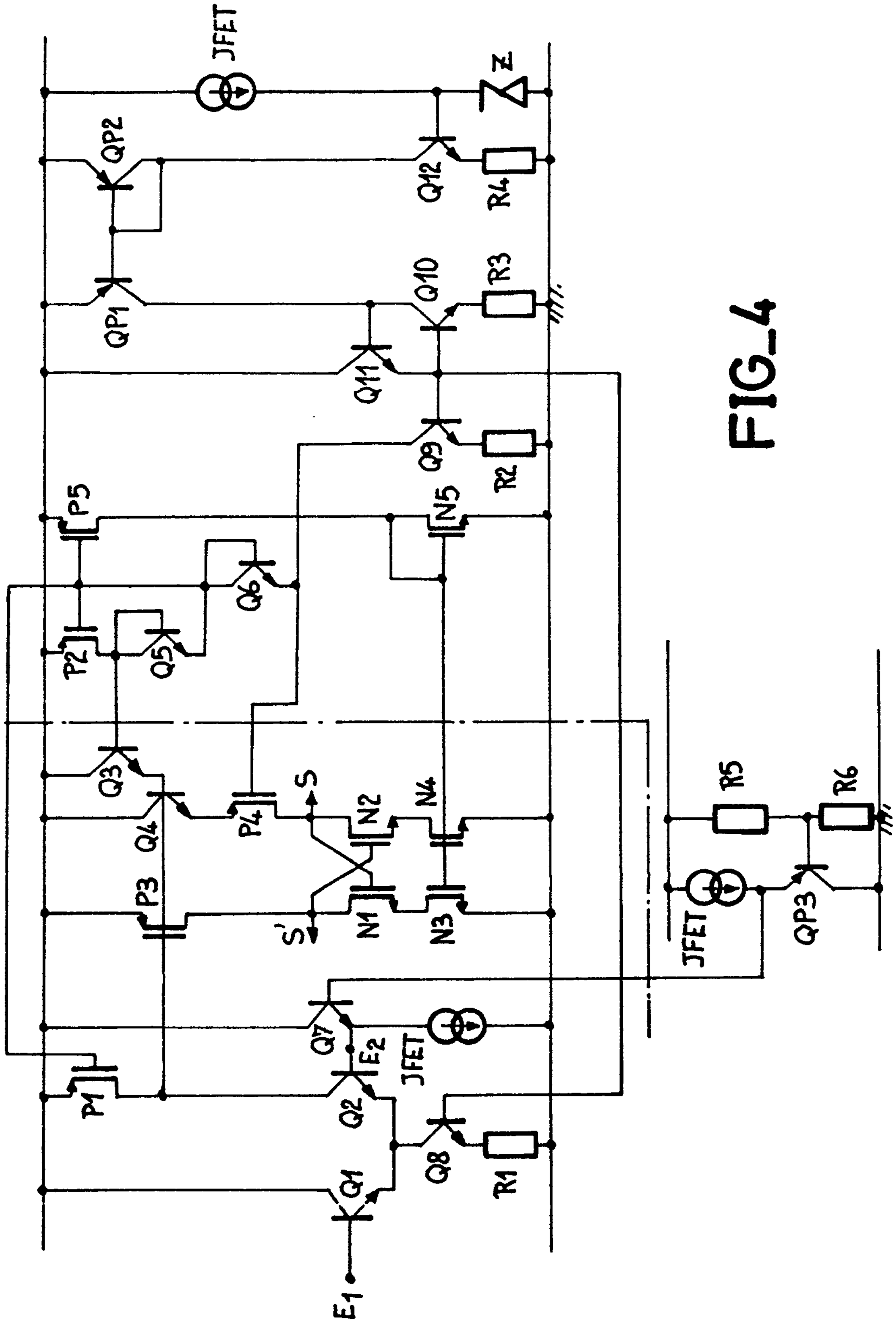
JFET
QP2
Z
QP1
Q12
R4
Q10
R3
Q11
Q9
R2
P5
N5
Q6
P2
Q5
Q3
Q4
P4
S
N2
N4
P3
N1
N3
S'
R5
R6
JFET
QP3
Q7
E2
JFET
P1
Q2
Q8
R1
Q1
E1

FIG_4